# FASCICULE DE BREVET EUROPEEN

(11) **EP 3 771 359 B1**
(45) Date de publication et mention de la délivrance du brevet: **10.05.2023**
(21) Numéro de dépôt: 19188836.1
(22) Date de dépôt: 29.07.2019
(51) Int. Cl.: A44C 17/04, G04B 47/04, A44C 25/00

(54) **PROCÉDÉ DE SERTISSAGE D'UNE PIERRE**
VERFAHREN ZUM FASSEN EINES STEINS
METHOD FOR CRIMPING A STONE

(43) Date de publication de la demande: 03.02.2021
(73) Titulaire: The Swatch Group Research and Development Ltd, 2074 Marin (CH)
(72) Inventeur: LAFORGE, Elias, 2000 Neuchâtel (CH)
(74) Mandataire: ICB SA

(56) Documents cités:
- EP-A1- 3 479 720

## Description

### DOMAINE TECHNIQUE

De manière générale, l'invention concerne un procédé d'assemblage d'une pierre notamment d'une pierre précieuse ou semi précieuse sur un support de fixation, la pierre étant taillée pour présenter une table, une couronne, un rondiste et une culasse.

### ARRIÈRE-PLAN TECHNOLOGIQUE

Il est connu de sertir des pierres précieuses, semi-précieuses ou synthétiques à l'aide de griffes, de grains ou de rails. Le sertissage traditionnel par montage d'une pierre naturelle, comme du diamant ou de l'émeraude, dans un chaton au moyen de griffes impose généralement une maitrise dimensionnelle de la taille des pierres proche des 5/100 mm. De ce fait, ce type de sertissage n'est pas compatible avec celui de pierres serties de grandes séries à faible coût utilisant quant à lui des pierres d'une plus grande précision, proche du 1/100 mm, telles que le diamant synthétique, le zircon et le rubis.

Le document EP 0900533 concerne un bijou creux comprenant une pierre d'ornementation insérée dans un chaton puis recouvert d'un matériau déposé par galvanoplastie, la pierre étant fixée par ledit matériau déposé galvaniquement qui entoure le chaton et la pierre.

Le document EP 2432632 concerne un procédé de fabrication d'un article pourvu d'une pierre précieuse, dans lequel la pierre précieuse est disposée dans ou sur un dispositif de maintien et dans lequel de la matière plastique est injectée derrière la pierre à l'aide d'une machine de moulage par injection. Le dispositif de maintien comprend une feuille de support sur ou à partir de laquelle la pierre précieuse est maintenue pendant le moulage par injection.

Le document EP 2421714 concerne un élément décoratif comprenant deux plaques sensiblement parallèles qui sont disposées à distance l'une de l'autre et dont au moins une est partiellement perméable à la lumière visible. Une pluralité de pierres précieuses est disposée entre les plaques. Un dispositif destiné à fixer les pierres précieuses dans une position spécifique est situé entre les plaques. Le dispositif de positionnement comprend des compartiments à l'intérieur desquels est disposée une pierre précieuse. Au moins une des plaques jouxte directement les compartiments.

Le document EP 3024351 concerne un procédé de fixation d'une pierre précieuse dans une coque en matériau fusible, la coque présentant un trou dans lequel la pierre précieuse est agencée. La pierre précieuse touche la coque en au moins un point. La pierre précieuse est chauffée par une source de chaleur jusqu'à ce que la coque passe dans un état au moins partiellement fondu dans la région du point de contact, de sorte qu'une liaison rigide entre la pierre précieuse et le boîtier puisse être établie après refroidissement. Le document EP3479720 décrit un procédé d'assemblage d'une pierre sur un support de fixation, comprenant les étapes de:
- mise à disposition d'un substrat revêtu d'une couche électriquement conductrice recouverte d'une couche de résine, un trou traversant le substrat;
- positionner la pierre dans le trou traversant; et
- déposer, par voie galvanique, une couche métallique sur la couche électriquement conductrice pour former le support de fixation, de manière à rendre solidaire la pierre à la couche métallique.

### PROBLÈME TECHNIQUE

L'objectif de la présente invention est d'améliorer les solutions existantes d'assemblage de pierres notamment précieuses ou semi précieuses sur un support de fixation ainsi que les solutions existantes de sertissage de pierres précieuses.

### DESCRIPTION GÉNÉRALE DE L'INVENTION

Un premier aspect de l'invention concerne un procédé d'assemblage d'une pierre sur un support de fixation, la pierre étant taillée pour présenter une table, une couronne, un rondiste et une culasse, le procédé comprenant les étapes de :
∘ mise à disposition d'un substrat revêtu d'un motif comprenant une couche électriquement conductrice recouverte d'une couche de résine, le motif ayant un contour intérieur délimitant un trou traversant le substrat revêtu et un contour extérieur correspondant au contour extérieur du support de fixation souhaité ;
∘ retirer de la couche de résine ;
∘ positionner, après la dissolution de la couche de résine, la pierre dans le trou traversant, la pierre reposant sur la couche électriquement conductrice ; et
∘ déposer, par voie galvanique, une couche métallique sur la couche électriquement conductrice pour former le support de fixation, de manière à rendre solidaire la pierre à la couche métallique.

De préférence, le positionnement de la pierre est réalisé de telle sorte que la culasse de la pierre repose sur la couche électriquement conductrice.

La pierre est de préférence d'origine naturelle. Selon un mode de réalisation particulier, la pierre est d'origine synthétique. La pierre peut, p. ex., être un diamant, une émeraude, une zircone, un rubis.

On comprendra que, dans le contexte de sertissage de pierre, un tel procédé permet avantageusement de s'affranchir des inévitables variations dimensionnelles typiquement rencontrées p. ex. lorsque des pierres naturelles sont utilisées. En effet, le procédé d'assemblage décrit ci-dessus permet de s'adapter aux variations dimensionnelles des pierres grâce à la mise à disposition de trous traversant de différentes dimensions, adaptées aux dimensions des pierres à assembler.

De préférence, la mise à disposition du substrat revêtu comprend les étapes consistant à :
∘ revêtir, préférablement par dépôt physique par phase vapeur (« Physical Vapor Déposition » (PVD) en anglais), le substrat d'une couche électriquement conductrice ;
∘ déposer une couche de résine photosensible sur la couche électriquement conductrice ; et
∘ photolithographier la couche de résine de façon que la résine restante après photolithographie soit délimitée par le contour intérieur et le contour extérieur du support de fixation souhaité.

La résine photosensible utilisée peut être soit une résine photosensible négative soit une résine photosensible positive.

La couche électriquement conductrice peut, par exemple, être obtenue par dépôt de nickel, de platine, d'argent, de chrome, de palladium, de titane, d'or, de nitrure de titane, de nitrure de chrome, de nitrure de zirconium, de cuivre ou d'une combinaison de ceux-ci.

La mise à disposition du substrat revêtu peut comprendre le retrait, préférablement par gravure humide, de la couche électriquement conductrice non recouverte par la couche de résine, de façon que la couche électriquement conductrice restante soit délimitée par le contour intérieur et le contour extérieur du support de fixation souhaité créant ainsi le motif comprenant la couche électriquement conductrice recouverte de la couche de résine. En d'autres termes, la couche de résine restante après photolithographie fait office de masque afin que la zone recouverte de la couche électriquement conductrice ne soit pas retirée.

De manière optionnelle, la mise à disposition du substrat revêtu comprend le perçage du trou traversant, de préférence par ablation laser.

Le retrait de la couche de résine peut comprendre la dissolution chimique de la couche de résine.

Selon un mode de réalisation, le procédé comprend la fixation, de préférence au moyen d'une colle, de la pierre positionnée dans le trou traversant.

Selon un mode de réalisation préféré, le procédé comprend la fixation, de préférence par une colle, de la culasse de la pierre positionnée dans le trou traversant.

Avantageusement, le procédé comprend une étape de correction de l'orientation de la pierre positionnée dans le trou traversant.

Selon un mode de réalisation, le procédé comprend une étape de correction de l'orientation de la pierre positionnée dans le trou traversant, suivie d'une étape de fixation, de préférence au moyen d'une colle, de la pierre positionnée dans le trou traversant.

Selon un mode de réalisation préféré, le procédé comprend une étape de correction de l'orientation de la pierre positionnée dans le trou traversant, suivie d'une étape de fixation, de préférence au moyen d'une colle, de la culasse pierre positionnée dans le trou traversant.

De préférence, la couche métallique est déposée de façon à englober le rondiste et des zones de la couronne et de la culasse contiguës au rondiste de manière à rendre solidaire la pierre à la couche métallique. La couche métallique emprisonne ainsi la pierre pour former le support de fixation.

La couche métallique déposée par voie galvanique peut être réalisée dans un matériau choisi parmi le groupe comprenant le nickel, l'or, l'argent, le platine, le rhodium, le palladium, le cuivre et leurs alliages.

Le substrat peut être réalisé à base d'un matériau choisi parmi le groupe comprenant le silicium, une céramique, un verre et un quartz.

Un second aspect concerne un procédé de sertissage d'une pierre sur un élément d'une pièce d'horlogerie ou de bijouterie comprenant le montage de la pierre et de son support de fixation obtenus selon le procédé d'assemblage généralement décrit ci-dessus sur un chaton rapporté sur l'élément de pièce d'horlogerie ou de bijouterie ou directement sur l'élément de pièce d'horlogerie ou de bijouterie.

Un troisième aspect concerne un élément de pièce d'horlogerie ou de bijouterie comprenant au moins une pierre assemblée sur son support de fixation obtenu selon le procédé d'assemblage généralement décrit ci-dessus.

### BRÈVE DESCRIPTION DES DESSINS

D'autres particularités et caractéristiques de l'invention ressortiront de la description détaillée de certains modes de réalisation avantageux présentés ci-dessous, à titre d'illustration, avec référence aux dessins annexés dans lesquels :
- La figure 1 représente un exemple de pierre comprenant une table, une couronne, un rondiste et une culasse ;
- Les figures 2 à 12 illustrent des étapes successives d'un procédé d'assemblage d'une pierre sur un support de fixation selon un mode de réalisation préféré de l'invention ;
- La figure 13 représente des vues de dessus de différentes variantes de formes de pierres et de supports de fixation obtenus selon plusieurs modes de réalisation du procédé; et
- La figure 14 représente une vue en coupe représentant une pierre et son support de fixation monté sur un chaton selon un mode de réalisation.

L'attention du lecteur est attirée sur le fait que les dessins ne sont pas à l'échelle. En outre, pour des raisons de clarté, les proportions entre hauteur, longueur et/ou largeur, et éventuellement les dimensions des espaces vides entre les éléments illustrés, peuvent ne pas être correctement représentées.

### DESCRIPTION DÉTAILLÉE DE PLUSIEURS MODES DE RÉALISATION DE L'INVENTION

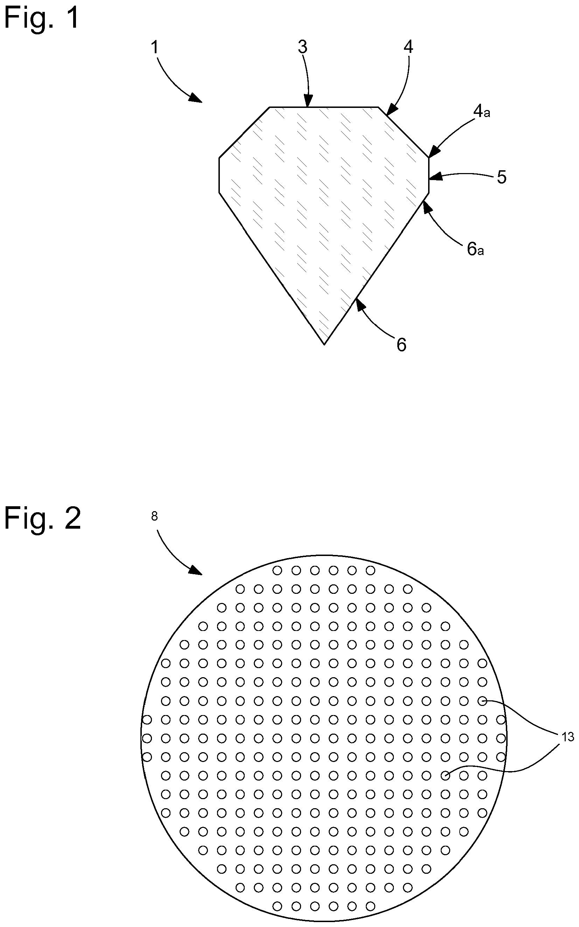

Un mode de réalisation préféré d'un procédé d'assemblage d'une pierre 1 sur un support de fixation 2 selon l'invention est décrit en référence aux figures 1 à 12. La pierre 1 est taillée pour présenter une table 3, une couronne 4, un rondiste 5 et une culasse 6 (voir figure 1). La pierre est de préférence une pierre d'origine naturelle, telle que du diamant ou de l'émeraude, dont les dimensions peuvent varier d'une pierre à l'autre. Il est bien évident que la pierre peut être de toute autre nature, naturelle ou synthétique, notamment précieuse ou semi précieuse, le procédé pouvant également être avantageusement utilisé pour de telles pierres.

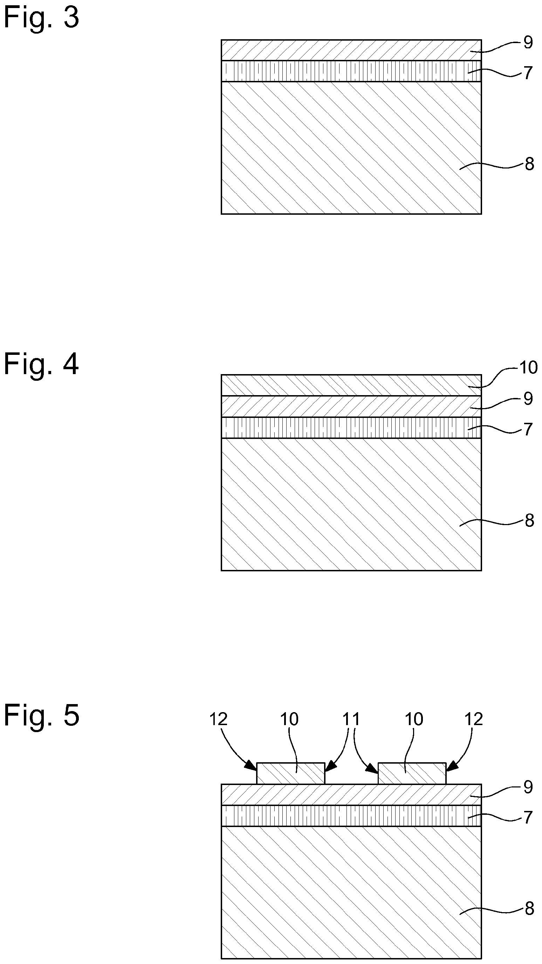

La première étape du procédé d'assemblage comprend une étape de dépôt d'une couche d'accroche 7 sur un substrat 8 par dépôt physique en phase vapeur avec pulvérisation cathodique au magnétron, suivie, sans mise à l'air, d'un dépôt physique en phase vapeur d'une couche électriquement conductrice 9 sur la couche d'accroche 7 (voir figure 3).

Le substrat 8 peut être un wafer silicium pour micro-électronique (tel que représenté p. ex. à la figure 2). Plusieurs pierres peuvent être assemblées à partir d'un substrat 8 (voir la pluralité de trous traversant 13 représentés à la figure 2).

Dans la suite, le procédé sera décrit pour l'assemblage d'une pierre sur un support de fixation 2, mais il est évident que les mêmes étapes du procédé peuvent être réalisées, éventuellement en parallèle, pour assembler plusieurs pierres sur un substrat 8.

La couche d'accroche 7 déposée est en titane. Alternativement ou additionnellement, la couche d'accroche 7 peut comprendre du tantale, du chrome et/ou du thorium. L'épaisseur de la couche d'accroche 7 est comprise entre 10 nm et 90 nm, de préférence entre 20 nm et 80 nm, de manière encore plus préférée entre 30 nm et 70 nm, et encore plus avantageusement entre 40 nm à 60 nm. Une épaisseur de la couche d'accroche 7 de (environ) 50 nm est particulièrement avantageuse.

La couche électriquement conductrice 9 déposée est réalisée en or. Il est à noter que la couche électriquement conductrice 9 peut être obtenue par dépôt d'or, de nickel, de platine, d'argent, de chrome, de palladium, de titane, de nitrure de titane, de nitrure de chrome, de nitrure de zirconium, ou d'une combinaison de ceux-ci. L'épaisseur de la couche électriquement conductrice 9 est comprise entre de 10 nm et 90 nm, de préférence entre 20 nm et 80 nm, plus préférablement entre 30 nm et 70 nm, encore plus préférablement entre 40 nm et 60 nm. Une épaisseur de la couche électriquement conductrice 9 de (environ) 50 nm est particulièrement avantageuse.

Une couche de résine 10 photosensible est ensuite déposée sur la couche électriquement conductrice 9 (voir figure 4). La résine photosensible peut, p. ex., être la résine AZ4562 (p. ex. de MicroChemicals GmbH) ou la résine SU-8. Une partie de la couche de résine 10 est retirée par photolithographie de sorte que la résine restante après photolithographie délimite le contour intérieur 11 et le contour extérieur 12 du support de fixation 2 souhaité. Un masque d'exposition correspondant au contour intérieur 11 et au contour extérieur 12 du support de fixation 2 souhaité peut être avantageusement utilisé lors de l'étape d'irradiation de la photolithographie. Dans le cas d'une résine photosensible négative (p. ex. SU-8), le masque d'exposition protège la partie de la couche de résine 10 que l'on souhaite retirer (la partie irradiée devient insoluble au révélateur (solvant) - la partie de résine photosensible non exposée reste soluble). Dans le cas d'une résine photosensible positive (p. ex. AZ4562), le masque d'exposition protège la partie de la couche de résine 10 que l'on souhaite garder (la partie irradiée devient soluble au révélateur (solvant) - la partie de résine photosensible non exposée reste insoluble). On comprendra que, lors de cette étape, il est très simple d'adapter la forme de résine restante après photolithographie et par conséquent la forme du support de fixation 2 final.

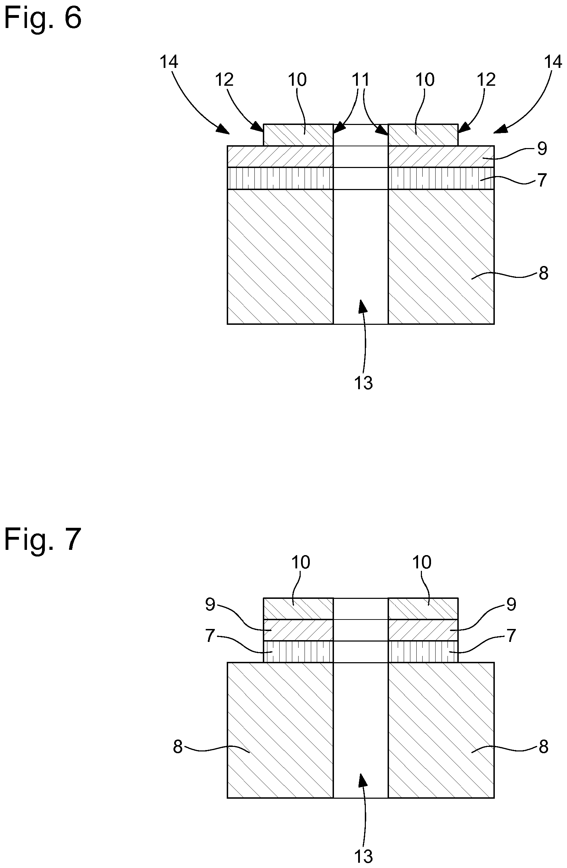

L'étape suivante comprend le perçage d'un trou traversant 13 le substrat 8, la couche d'accroche 7, la couche électriquement conductrice 9 et la couche de résine 10 photolithographiée, par ablation laser (voir figure 6). Le perçage est réalisé de sorte que le trou traversant 13 est délimité par le contour intérieur 11 de la couche de résine 10 photolithographiée (voir figure 6). Avantageusement, lorsque plusieurs pierres sont à assembler sur un substrat 8, la répartition des trous traversant 13 sur le substrat 8 est optimisée notamment en fonction des dimensions délimitées par les contours intérieurs 11, de la forme des supports de fixation, etc..., afin d'avoir un nombre maximum de trous traversant 13 sur le substrat 8 (voir p. ex. la répartition représentée à la figure 2).

A la figure. 7, la partie de la couche électriquement conductrice 9 non recouverte 14 par la couche de résine 10 (voir figure 6) a été retirée par gravure humide. Après gravure, la couche électriquement conductrice 9 restante est délimitée par le contour intérieur 11 et le contour extérieur 12 du support de fixation 2 souhaité. La couche électriquement conductrice 9 en or peut être gravée, p. ex., avec de l'eau régale (acide chlorhydrique et acide nitrique) ou du KI (iodure de potassium) ou du KCN (cyanure de potassium). La partie de la couche d'accroche 7 non recouverte par la couche électriquement conductrice 9 (après gravure humide de celle-ci) est aussi retirée par gravure humide. Après gravure, la couche d'accroche 7 restante est aussi délimitée par le contour intérieur 11 et le contour extérieur 12 du support de fixation 2 souhaité. La couche d'accroche 7 en titane peut être gravée, p. ex., avec de l'acide fluorhydrique ou de l'oxyde gravant tamponné (« buffered oxide etch » (BOE) en anglais). Le substrat 8 est maintenant revêtu d'un motif comprenant une couche électriquement conductrice 9 recouverte d'une couche de résine 10, le motif ayant un contour intérieur 11 délimitant le trou traversant 13 et un contour extérieur 12 correspondant au contour extérieur 12 du support de fixation 2 souhaité.

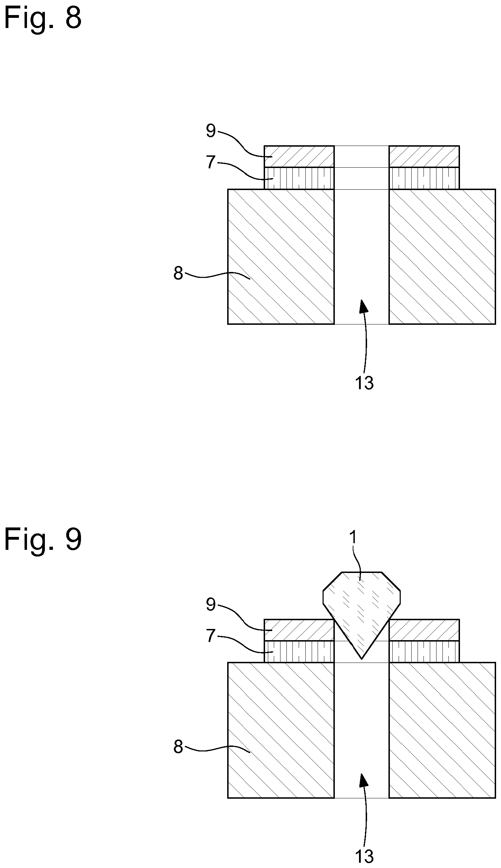

La couche de résine 10 photolithographiée est ensuite dissoute chimiquement, p. ex., à l'acétone (voir figure 8) et la pierre 1 est positionnée dans le trou traversant 13 de sorte que la culasse 6 de la pierre 1 repose sur la couche électriquement conductrice 9 (voir figure 9).

Il est à noter que les seules dimensions précises de la pierre pouvant être assurées sont le diamètre du rondiste 5 et sa hauteur, il est donc possible que le positionnement de la pierre 1 ne se fasse pas correctement. En particulier, il est possible qu'un parallélisme suffisant de la surface de la table 3 de la pierre 1 avec la surface supérieure du substrat 8 ne soit pas assuré lors du positionnement (voir p. ex. la pierre à la figure 9).

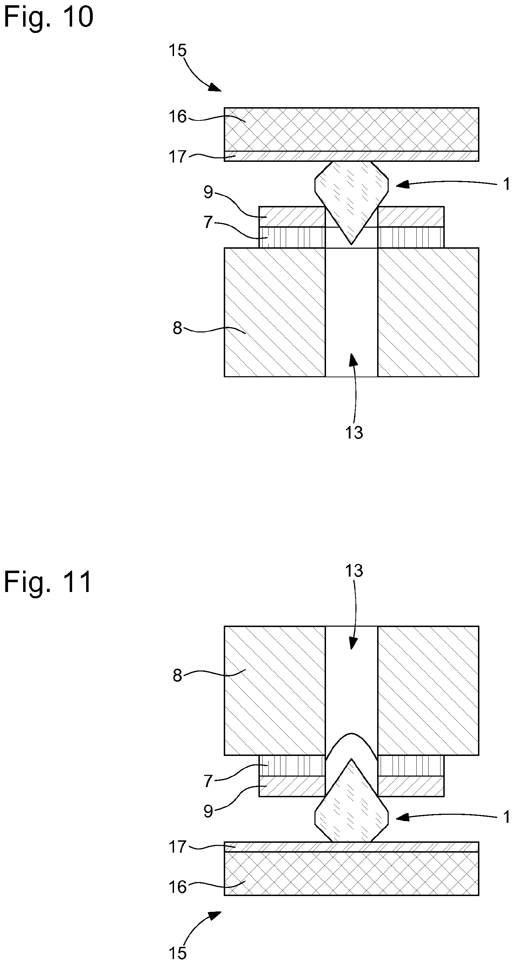

Une étape de correction de l'orientation de la pierre 1 est mise en oeuvre afin de corriger l'éventuel défaut d'orientation de la table 3 de la pierre 1 par rapport à la surface supérieure du substrat. D'une manière avantageuse, et en référence à la figure 10, cette étape peut comprendre la mise en contact de la table 3 de la pierre 1 avec un dispositif de repositionnement 15 agencé pour repositionner la pierre 1 dans le trou traversant 13. Un tel dispositif de repositionnement 15 comprend par exemple une plaque rigide 16 revêtue d'une couche d'un matériau déformable élastiquement ou d'une mousse 17 permettant de compenser la hauteur de la pierre 1. Le dispositif de repositionnement 15 est agencé pour que le matériau déformable ou la mousse 17 soit mis en contact avec la table 3 de la pierre 1 positionnée dans le trou traversant 13 de manière à corriger l'orientation de la pierre 1 et à assurer le parallélisme de la table 3 de la pierre 1 avec la surface supérieure du substrat. On comprendra que dans le cas où plusieurs pierres sont à assembler sur un substrat 8, cette étape peut être réalisée simultanément pour plusieurs pierres, éventuellement pour toutes les pierres p. ex. avec un dispositif de repositionnement 15 de dimensions semblables au substrat 8.

Avant de retirer le dispositif de repositionnement 15, la culasse 6 de la pierre 1 est fixée dans le trou traversant 13. Cette étape permet de conserver le positionnement correct de la pierre 1 dans le trou traversant 13, même après avoir retiré le dispositif de repositionnement 15. On peut, par exemple, introduire, par l'entrée libre du trou traversant 13, une colle de maintien 18 autour de la culasse 6 de la pierre 1 permettant de fixer la pierre 1 dans le trou traversant 13 (voir Fig. 11). Afin d'éviter que la colle 18 ne passe au travers d'interstices entre la pierre 1 et la couche électriquement conductrice 9, on peut utiliser une colle 18 suffisamment visqueuse qui ne remplira pas les interstices les plus fins. Il est également possible de boucher les interstices existants entre la pierre 1 et la couche électriquement conductrice 9, préalablement au dépôt de la colle de maintien 18. A cet effet, on peut pulvériser dans les interstices, du côté opposé à la culasse 6 de la pierre 1 (côté bouché du trou traversant 13 - c. à d. le côté opposé au côté de l'entrée libre du trou traversant 13), une résine qui pourra facilement être éliminée (par dissolution par exemple). Il est également possible de prévoir un dépôt d'une couche d'indium de 50 µm environ sur le substrat 8 de silicium avant la mise en place de la pierre 1. La couche d'indium présente l'avantage de se déformer lors de la correction de l'orientation de la pierre 1 par la mise à niveau de la table 3 et de pouvoir ensuite assurer l'étanchéité.

Le dispositif de repositionnement 15 est ensuite retiré.

L'étape suivante du procédé comprend le dépôt, par voie galvanique, d'une couche métallique 19 sur la couche électriquement conductrice 9 pour former le support de fixation 2. La couche métallique 19 déposée est de préférence réalisée dans un matériau choisi parmi le groupe comprenant le nickel, l'or, l'argent, le platine, le rhodium, le palladium, le cuivre et leurs alliages.

La couche métallique 19 est réalisée par un dépôt par voie galvanique à partir de la couche électriquement conductrice 9 autour de la pierre 1 pour recouvrir au moins les zones 4a, 6a de la couronne 4 et le cas échéant de la culasse 6, disposées respectivement, de part et d'autre du rondiste 5 (voir figure. 1). En d'autres termes, la couche métallique 19 englobe (recouvre) le rondiste 5 et les zones 4a, 6a de la couronne 4 et de préférence de la culasse 6, respectivement, contiguës au rondiste 5. Le rondiste 5 de la pierre 1 est ainsi emprisonné dans la couche métallique 19 pour former, au moins sensiblement autour du rondiste 5 de la pierre 1, le support de fixation 2. La pierre 1 est désormais solidaire du support de fixation 2. Il est à noter qu'il est préférable que l'essentiel de la couronne 4 et de la culasse 6 reste libre pour exposer le maximum de surface de la pierre tout en respectant un recouvrement de la couronne et de la culasse avec une quantité de matière permettant un maintien fiable de la pierre 1 dans la couche 19.

Les conditions pour le dépôt par voie galvanique (aussi appelé électroformage), notamment la composition des bains, la géométrie du système, les tensions et densités de courant, sont choisis pour chaque métal ou alliage à électro-déposer selon les techniques bien connues dans l'art de l'électroformage (cf. par exemple Di Bari G.A. "electroforming" Electroplating Engineering Handbook 4th Edition rédigée par L.J. Durney, publié par Van Nostrand Reinhold Compagny Inc., N.Y. USA 1984).

Les dimensions du support de fixation 2 sont définies par les dimensions, dans le plan du substrat 8, de la couche électriquement conductrice 9, et par la hauteur de la couche métallique 19 déposée selon les paramètres de dépôt galvanique.

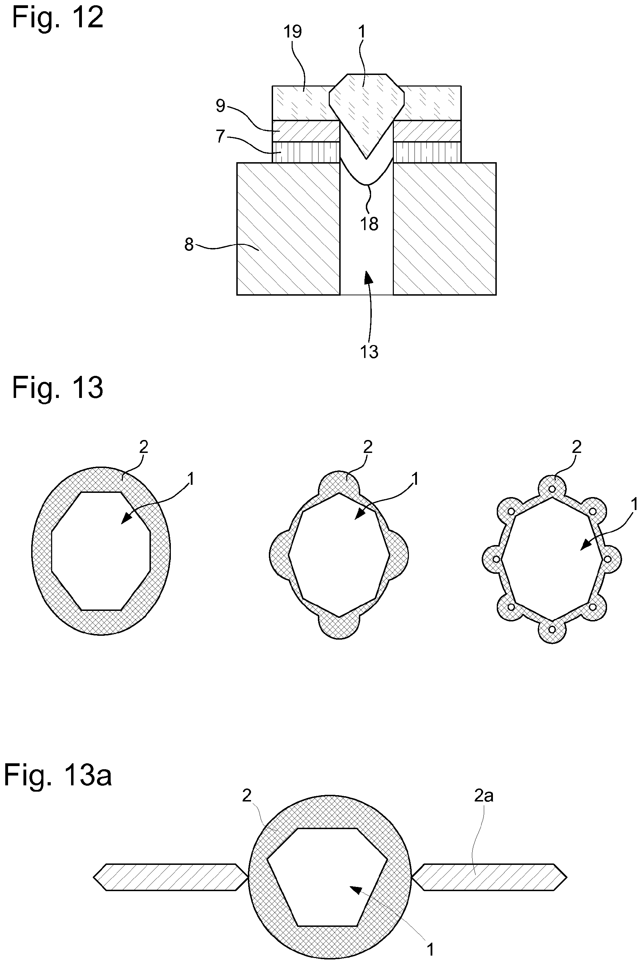

Il est à noter que, pour permettre le dépôt de la couche métallique 19 par voie galvanique, il faut connecter la couche électriquement conductrice 9 à des pistes de conduction pour ramener le courant. Le métal va ainsi aussi croître sur les pistes de conduction lors du dépôt par voie galvanique. Un avantage de la présente invention est de permettre de libérer facilement la pierre des pistes de conduction par l'application d'une force aux points de connexion. Ceci est rendu possible, entre autre, par le faible encombrement autour de la couche métallique 19 déposée. Un exemple de configuration de pistes de conduction 2a est illustré à la figure 13a, cette configuration permettant une libération aisée des pierres 1.

La pierre 1 assemblée sur son support de fixation 2 est ensuite libérée du substrat 8 et de la colle de maintien 18. À cet effet, on élimine le substrat 8 ainsi que la colle de maintien 18 par dissolution. On pourra utiliser par exemple de l'hydroxyde de potassium KOH 20% chauffé à 85°C pour dissoudre le substrat 8 en silicium, et un solvant commercial (p. ex. l'acétone) pour dissoudre la colle.

La figure 13 montre des exemples de géométries de supports de fixation 2 qu'il est possible d'obtenir avec un procédé d'assemblage tel que décrit ci-dessus, p. ex. grâce à différentes géométries de masques d'exposition photolithographiques.

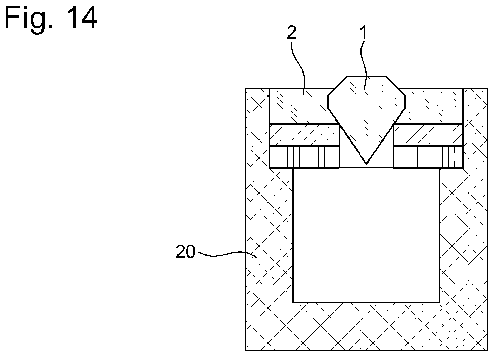

La pierre 1 assemblée sur son support de fixation 2 ainsi libérée peut être utilisée dans le procédé de sertissage. Le procédé de sertissage de la pierre sur un élément d'une pièce d'horlogerie ou de bijouterie comprend le montage de la pierre 1 et de son support de fixation 2, obtenus selon le procédé d'assemblage tel que décrit ci-dessus, sur un chaton 20 (comme représenté p. ex. à la figure 14). Le chaton 20 est ensuite rapporté classiquement, par exemple par chassage dans un logement approprié de l'élément de pièce d'horlogerie ou de bijouterie.

Alternativement, la pierre 1 et son support de fixation 2, obtenus selon le procédé d'assemblage tel que décrit ci-dessus, sont montés directement sur l'élément de pièce d'horlogerie ou de bijouterie.

Le montage du support de fixation 2 portant la pierre 1 sur le chaton 20 ou directement sur l'élément de pièce d'horlogerie ou de bijouterie peut être réalisé par clippage, chassage, sertissage, collage, etc.

L'élément de pièce d'horlogerie ou de bijouterie peut être par exemple un cadran, une lunette, une lunette tournante, une carrure, une corne de la boite, une couronne, une aiguille, un index, un maillon ou autre élément de bracelet, un élément de pendentif, de bague, de collier, etc., ou tout élément décor d'horlogerie/bijouterie pouvant être serti.

Alors que des modes de réalisation particuliers viennent d'être décrits en détail, l'homme du métier appréciera que diverses modifications et alternatives à ceux-là puissent être envisagées à la lumière de l'enseignement global apporté par la présente description. Par conséquent, les agencements et/ou procédés spécifiques décrits ci-dedans sont censés être donnés uniquement à titre d'illustration, sans intention de limiter la portée de l'invention qui est définie par les revendications.

## Revendications

1. Procédé d'assemblage d'une pierre (1) sur un support de fixation (2), la pierre (1) étant taillée pour présenter une table (3), une couronne (4), un rondiste (5) et une culasse (6), comprenant les étapes de :
- mise à disposition d'un substrat (8) revêtu d'un motif comprenant une couche électriquement conductrice (9) recouverte d'une couche de résine (10), le motif ayant un contour intérieur (11) délimitant un trou traversant (13) le substrat (8) revêtu et un contour extérieur (12) correspondant au contour extérieur (12) du support de fixation (2) souhaité ;
- retirer la couche de résine (10) ;
- positionner, après la dissolution de la couche de résine (10), la pierre (1) dans le trou traversant (13), la pierre (1) reposant sur la couche électriquement conductrice (9) ; et
- déposer, par voie galvanique, une couche métallique (19) sur la couche électriquement conductrice (9) pour former le support de fixation (2), de manière à rendre solidaire la pierre (1) à la couche métallique (19).

2. Procédé selon la revendication 1, dans lequel la mise à disposition du substrat (8) revêtu comprend les étapes de :
revêtir, préférablement par dépôt physique par phase vapeur, le substrat (8) par une couche électriquement conductrice (9) ;
déposer une couche de résine (10) photosensible sur la couche électriquement conductrice (9) ; et
photolithographier de la couche de résine (10) de sorte que la résine restante après photolithographie est délimitée par le contour intérieur (11) et le contour extérieur (12) du support de fixation (2) souhaité.

3. Procédé selon la revendication 2, dans lequel la mise à disposition du substrat (8) revêtu comprend le retrait, préférablement par gravure humide, de la couche électriquement conductrice (9) non recouverte par la couche de résine (10), de sorte que la couche électriquement conductrice (9) restante est délimitée par le contour intérieur (11) et le contour extérieur (12) du support de fixation (2) souhaité créant ainsi le motif comprenant la couche électriquement conductrice (9) recouverte de la couche de résine (10).

4. Procédé selon l'une quelconque des revendications 1 à 3, dans la lequel mise à disposition du substrat (8) revêtu comprend le perçage du trou traversant (13), préférablement par ablation laser.

5. Procédé selon l'une quelconque des revendications 1 à 4, dans lequel le retrait de la couche de résine (10) comprend la dissolution chimique de la couche de résine (10).

6. Procédé selon l'une quelconque des revendications 1 à 5, comprenant la fixation, préférablement par une colle de maintien (18), de la pierre (1) positionnée dans le trou traversant (13).

7. Procédé selon l'une quelconque des revendications 1 à 6, comprenant la correction de l'orientation de la pierre (1) positionnée dans le trou traversant (13).

8. Procédé selon la revendication 7, comprenant la correction de l'orientation de la pierre (1) positionnée dans le trou traversant (13), suivie de la fixation, préférablement par une colle de maintien (18), de la pierre (1) positionnée dans le trou traversant (13).

9. Procédé selon l'une quelconque des revendications 1 à 8, dans lequel la déposition est réalisée de sorte que la couche métallique (19) englobe le rondiste (5) et des zones de la couronne (4) et de la culasse (6) contiguës au rondiste (5) de manière à rendre solidaire la pierre (1) à la couche métallique (19), la couche métallique (19) emprisonnant ainsi la pierre (1) pour former le support de fixation (2).

10. Procédé selon l'une quelconque des revendications 1 à 9, dans lequel la couche métallique (19) déposée par voie galvanique est réalisée dans un matériau choisi parmi le groupe comprenant le nickel, l'or, l'argent, le platine, le rhodium, le palladium, le cuivre et leurs alliages.

11. Procédé selon l'une quelconque des revendications 1 à 10, dans lequel le substrat (8) est à base d'un matériau choisi parmi le groupe comprenant le silicium, une céramique, un verre et un quartz.

## Patentansprüche

1. Verfahren zum Verbinden eines Steins (1) auf einer Befestigungshalterung (2), wobei der Stein (1) geschliffen ist, um eine Tafel (3), einen Oberteil (4), eine Rondiste (5) und einen Unterteil (6) aufzuweisen, das die folgenden Schritte umfasst:
- Bereitstellen eines mit einem Motiv beschichteten Substrats (8), das eine elektrisch leitende Schicht (9) umfasst, die mit einer Harzschicht (10) bedeckt ist, wobei das Motiv eine Innenkontur (11) hat, die ein Loch (13) begrenzt, das das beschichtete Substrat (8) durchquert und eine Außenkontur (12), die der Außenkontur (12) der gewünschten Befestigungshalterung (2) entspricht;
- Entfernen der Harzschicht (10);
- Positionieren, nach dem Auflösen der Harzschicht (10), des Steins (1) im Durchgangsloch (13), wobei der Stein (1) auf der elektrisch leitenden Schicht (9) ruht; und
- Aufbringen einer Metallschicht (19) auf der elektrisch leitenden Schicht (9) auf galvanischem Weg, um die Befestigungshalterung (2) derart zu bilden, dass der Stein (1) mit der Metallschicht (19) fest verbunden wird.

2. Verfahren nach Anspruch 1, wobei das Bereitstellen des beschichteten Substrats (8) die folgenden Schritte umfasst:
Beschichten des Substrats (8) mit einer elektrisch leitenden Schicht (9) vorzugsweise durch physikalisches Aufbringen durch Dampfphase;
Aufbringen einer lichtempfindlichen Harzschicht (10) auf die elektrisch leitende Schicht (9); und
Photolithographieren der Harzschicht (10), so dass das nach der Photolithographie verbliebene Harz von der Innenkontur (11) und der Außenkontur (12) der gewünschten Befestigungshalterung (2) begrenzt wird.

3. Verfahren nach Anspruch 2, wobei das Bereitstellen des beschichteten Substrats (8) das Entfernen der von der Harzschicht (10) nicht bedeckten elektrisch leitenden Schicht (9) vorzugsweise durch Nassätzen umfasst, so dass die verbleibende elektrisch leitende Schicht (9) von der Innenkontur (11) und der Außenkontur (12) der gewünschten Befestigungshalterung (2) begrenzt wird, wodurch das Motiv geschaffen wird, das die mit der Harzschicht (10) bedeckte elektrisch leitende Schicht (9) umfasst.

4. Verfahren nach einem der Ansprüche 1 bis 3, wobei das Bereitstellen des beschichteten Substrats (8) das Bohren des Durchgangslochs (13) vorzugsweise durch Laserablation umfasst.

5. Verfahren nach einem der Ansprüche 1 bis 4, wobei das Entfernen der Harzschicht (10) das chemische Auflösen der Harzschicht (10) umfasst.

6. Verfahren nach einem der Ansprüche 1 bis 5, umfassend das Befestigen des im Durchgangsloch (13) positionierten Steins (1) vorzugweise durch einen Haltekleber (18).

7. Verfahren nach einem der Ansprüche 1 bis 6, umfassend das Korrigieren der Ausrichtung des im Durchgangsloch (13) positionierten Steins (1).

8. Verfahren nach Anspruch 7, umfassend das Korrigieren der Ausrichtung des im Durchgangsloch (13) positionierten Steins (1), gefolgt vom Befestigen des im Durchgangsloch (13) positionierten Steins (1) vorzugsweise durch einen Haltekleber (18).

9. Verfahren nach einem der Ansprüche 1 bis 8, wobei das Aufbringen derart durchgeführt wird, dass die Metallschicht (19) die Rondiste (5) und die Zonen des Oberteils (4) und des Unterteils (6) einschließt, die an die Rondiste (5) angrenzen, so dass der Stein (1) mit der Metallschicht (19) fest verbunden wird, wobei die Metallschicht (19) somit den Stein (1) umschließt, um die Befestigungshalterung (2) zu bilden.

10. Verfahren nach einem der Ansprüche 1 bis 9, wobei die galvanisch aufgebrachte Metallschicht (19) aus einem Material hergestellt wird, das aus der Gruppe ausgewählt ist, die Nickel, Gold, Silber, Platin, Rhodium, Palladium, Kupfer und deren Legierungen umfasst.

11. Verfahren nach einem der Ansprüche 1 bis 10, wobei das Substrat (8) auf einem Material basiert, das aus der Gruppe ausgewählt ist, die Silizium, eine Keramik, ein Glas und ein Quarz umfasst.

## Claims

1. Method for assembling a stone (1) on a setting support (2), the stone (1) being cut to exhibit a table (3), a crown (4), a girdle (5) and a pavilion (6), including the steps of:
- providing a substrate (8) coated with a pattern comprising an electrically conductive layer (9) covered with a resin layer (10), the pattern having an inner contour (11) delimiting a hole (13) through the coated substrate (8) and an outer contour (12) corresponding to the outer contour (12) of the desired setting support (2);
- removing the resin layer (10);
- after dissolution of the resin layer (10), positioning the stone (1) in the through hole (13), the stone (1) resting on the electrically conductive layer (9); and
- electrodepositing a metal layer (19) on the electrically conductive layer (9) to form the setting support (2), in order to make the stone (1) integral with the metal layer (19).

2. Method according to claim 1, wherein the provision of the coated substrate (8) includes the steps of:
coating the substrate (8), preferably by physical vapour deposition, with an electrically conductive layer (9);
depositing a photosensitive resin layer (10) on the electrically conductive layer (9); and
applying a photolithography process to the resin layer (10) such that the resin remaining after photolithography is delimited by the inner contour (11) and the outer contour (12) of the desired setting support (2).

3. Method according to claim 2, wherein the provision of the coated substrate (8) includes the removal, preferably by wet etching, of the electrically conductive layer (9) not covered by the resin layer (10), so that the remaining electrically conductive layer (9) is delimited by the inner contour (11) and the outer contour (12) of the desired setting support (2) thereby creating the pattern comprising the electrically conductive layer (9) covered with the resin layer (10).

4. Method according to any of claims 1 to 3, wherein the provision of the coated substrate (8) includes drilling the through hole (13), preferably by laser ablation.

5. Method according to any of claims 1 to 4, wherein the removal of the resin layer (10) includes the chemical dissolution of the resin layer (10).

6. Method according to any of claims 1 to 5, comprising the securing, preferably by a retention adhesive (18), of the stone (1) positioned inside the through hole (13).

7. Method according to any of claims 1 to 6 comprising the correction of the orientation of the stone (1) positioned inside the through hole (13).

8. Method according to claim 7 comprising the correction of the orientation of the stone (1) positioned inside the through hole (13), followed by the securing, preferably by a retention adhesive (18), of the stone (1) positioned inside the through hole (13).

9. Method according to any of claims 1 to 8, wherein the deposition is made such that the metal layer (19) encompasses the girdle (5) and areas of the crown (4) and of the pavilion (6) contiguous to the girdle (5) in order to make the stone (1) integral with the metal layer (19), the metal layer (19) thereby imprisoning the stone (1) to form the setting support (2).

10. Method according to any of claims 1 to 9, wherein the electrodeposited metal layer (19) is made of a material chosen from the group including nickel, gold, silver, platinum, rhodium, palladium, copper and alloys thereof.

11. Method according to any of claims 1 to 10, wherein the substrate (8) is made from a material chosen from the group including silicon, ceramic, glass and quartz.
